# EUROPÄISCHE PATENTSCHRIFT

(11) **EP 0 950 190 B1**
(45) Veröffentlichungstag und Bekanntmachung des Hinweises auf die Patenterteilung: **11.04.2001**
(21) Anmeldenummer: 98905214.7
(22) Anmeldetag: 05.01.1998
(51) Int. Cl.: G01P 15/08

(54) **Verfahren zur Herstellung einer mikromechanischen Halbleiteranordnung**
Method for the production of a micromechanical semiconductor array
Procédé de production d'un ensemble micromécanique à semiconducteur

(30) Priorität: 03.01.1997 DE 19700290
(43) Veröffentlichungstag der Anmeldung: 20.10.1999
(73) Patentinhaber: Infineon Technologies AG, 81669 München (DE)
(72) Erfinder: MÜLLER, Karlheinz, D-84478 Waldkraiburg (DE); KOLB, Stefan, D-85716 Unterschlei heim (DE)
(74) Vertreter: Zedlitz, Peter, Dipl.-Inf.
(86) Internationale Anmeldenummer: DE9800012
(87) Internationale Veröffentlichungsnummer: WO9829748

(56) Entgegenhaltungen:
- EP-A- 0 624 900
- EP-A- 0 747 686
- DE-A- 4 215 722

## Beschreibung

Die Erfindung betrifft ein Verfahren zur Herstellung einer mikromechanischen Halbleiteranordnung.

Eine solche mikromechanische Halbleiteranordnung wird beispielsweise in der Form eines Halbleiterbeschleunigungssensors zur Messung von Beschleunigungen eingesetzt. Die Membran dient dabei zusammen mit Gegenelektroden als Kondensator, wobei Kapazitätsänderungen als Messgröße ausgewertet werden. Üblicherweise sind die bisher bekannten Membranen über Federn im Sensor verankert. Die Prozessabläufe bei der Herstellung der Membran führen jedoch zu Stress, insbesondere mechanischem Stress in der Membran. Bei einer nicht vollständigen Relaxierung durch die Federn kann sich die Membran dadurch dauerhaft verbiegen. Weiterhin können die in den Federn aufgenommenen Kräfte zu einem Fehlverhalten der Membran während des Betriebs führen. Zum Schutz und zur mechanischen Stabilisierung dieser Sensoren werden obere Verschlussplatten, die in der Regel aus einer Polysiliziumschicht bestehen, mit Hilfe von z.B. Nitridstützen abgestützt. Ebenso können die Verschlussplatten aus einer Metallisierung gebildet und mit Metallisierungsstützen abgestützt werden. In jedem Falle sind zur Ausbildung des Sensors Zusatzschichten erforderlich.

Der Erfindung liegt die Aufgabe zugrunde, ein Verfahren zur Herstellung einer mikromechanischen Halbleiteranordnung der eingangs genannten Art zur Verfügung zu stellen, damit sie einfacher und damit kostengünstiger hergestellt werden kann, und gleichzeitig ein Zugewinn an mechanischen und physikalischen Eigenschaften erreicht wird.

Die Lösung dieser Aufgabe erfolgt mit den kennzeichnenden Merkmalen des Anspruchs 1.

Nach einem wesentlichen Gedanken der Erfindung ist die Membran durch eine kristalline Schicht innerhalb des Substrates oder innerhalb einer auf einem Substrat angeordneten epitaktischen Schichtenfolge der Halbleiteranordnung ausgebildet. Zur Herstellung der mikromechanischen Halbleiteranordnung werden somit keine von den in der Halbleiterfertigung üblichen Schichten abweichende Schichten verwendet; vielmehr kann der bei üblichen Halbleiter-Bauelementen verwendete Standardprozess auch für die Herstellung einer Membran in einem Hohlraum in der mikromechanischen Halbleiteranordnung übernommen werden, wobei lediglich geringfügige Prozess-Schritte eingefügt bzw. ergänzt werden müssen. Von Vorteil wird die gesamte mikromechanische Halbleiteranordnung aus nur einem zusammenhängenden kristallinen Halbleiter-Grundmaterial hergestellt, welches entweder das eigentliche Substrat oder eine auf einem Substrat angeordnete epitaktische Schichtenfolge darstellt. Dem Prinzip der Erfindung folgend ist die Membran insbesondere aus einer monokristallinen Silizium-Schicht gebildet. Die wesentlichen Vorteile liegen neben den günstigen Herstellungskosten vor allem bei der Verwendung einer annähernd stressfreien einkristallinen Schicht für die Membran und damit in einem Zugewinn der mechanischen und sonstigen physikalischen Eigenschaften.

In einer bevorzugten Ausführungsform ist die Membran am Randbereich an einem Auflager aufgelegt, und mit einer auf einem Gegenlager abgestützten Deckschicht überdeckt. Gegenlager und Deckschicht wirken hierbei auch als seitliche und obere Bewegungsbegrenzungen, die in der Weise bezüglich des Randes der Membran angeordnet sind, dass Ausgleichsbewegungen der Membran von mechanischem Stress möglich sind.

Bei der Erfindung wird das Auflager, die Membran, das Gegenlager, und die Deckschicht in dieser Reihenfolge jeweils durch eine kristalline Schicht innerhalb des Substrates oder innerhalb einer auf dem Substrat angeordneten epitaktischen Schichtenfolge hergestellt, wobei im Substrat bzw. der epitaktischen Schichtenfolge ein Dotierungsprofil dergestalt eingestellt wird, dass wenigstens das Auflager und das Gegenlager einerseits und die Membran andererseits so weit unterschiedlich dotiert sind, dass vermittels einer geeigneten selektiven Ätzlösung zur Fertigung eines Hohlraums die die Membran umgebenden Schichten bereichsweise nass-chemisch geätzt werden können. Die Einstellung des Dotierungsprofils kann entweder nachträglich über eine oder mehrere durchzuführende Hochenergieimplantationsschritte, oder bereits bei der Abscheidung von unterschiedlich dotierten Epitaxieschichten erreicht werden. Bei einer bevorzugten Ausführungsform werden die aufeinanderfolgenden Schichten des Substrates bzw. der epitaktischen Schichtenfolge abwechselnd hoch und niedrig dotiert. In Abhängigkeit der zum Einsatz gelangenden Ätzlösung können demnach entweder die hoch dotierten Gebiete beispielsweise vermittels einer HF-HNO₃-CH₃COOH-Ätzlösung oder die niedrig dotierten Gebiete beispielsweise vermittels einer KOH-Ätzlösung nach einem nass-chemischen Freiätzverfahren entfernt werden. Hierbei wird die Selektivität bei der entsprechenden nass-chemischen Ätzung zwischen hoch dotierten Schichten und niedrig dotierten Schichten ausgenutzt, wobei Selektivitäten von mehr als etwa 50:1 erzielt werden können.

Darüber hinaus können die aufeinanderfolgenden Gebiete im Substrat bzw. in der epitaktischen Schichtenfolge aufeinanderfolgend in der Dotierung zwischen einer p-Dotierung und einer n-Dotierung wechseln, was darüber hinaus den Vorteil der elektrischen Trennung der aufeinanderfolgenden Schichten bietet.

In der die Auflagerschicht zunächst überdeckenden Membran werden günstigerweise Ätzlöcher vorgesehen, die ein Eindringen der Ätzlösung in die darunter liegende Schicht ermöglichen. Zu dem gleichen Zweck kann auch die Deckschicht mit entsprechenden Ätzlöchern versehen sein, wobei letztere zur Ausbildung eines vollständig abgeschlossenen Hohlraums in einem späteren Verfahrensschritt wieder verschlossen werden, vorzugsweise vermittels einer fließfähigen Glasschicht wie BPSG oder dergleichen.

Die mikromechanische Halbleiteranordnung kann mit Erfolg in allen Bereichen zum Einsatz gelangen, wo mikromechanische Strukturen mit Membranen in Hohlräumen benötigt werden. Insbesondere kann die mikromechanische Halbleiteranordnung gemäß Erfindung als Halbleiter-Beschleunigungssensor oder als Halbleiter-Mikropumpe verwendet werden.

Nachfolgend wird die Erfindung anhand eines in der Zeichnung dargestellten Ausführungsbeispiels weiter erläutert. Im Einzelnen zeigen die schematischen Darstellungen in:
- Figur 1: einen schematischen Querschnitt durch die auf einem Substrat angeordnete epitaktische Schichtenfolge und zugehörendem Dotierungsprofil;
- Figur 2: eine schematische Schnittansicht einer mikromechanischen Halbleiteranordnung gegen Ende des Herstellungsverfahrens;
- Figur 3: eine schematische Draufsicht der mikromechanischen Halbleiteranordnung; und
- Figur 4: einen schematischen Querschnitt durch die auf einem Substrat angeordnete epitaktische Schichtenfolge und zugehörendem Dotierungsprofil gemäß einem weiteren Ausführungsbeispiel der Erfindung.

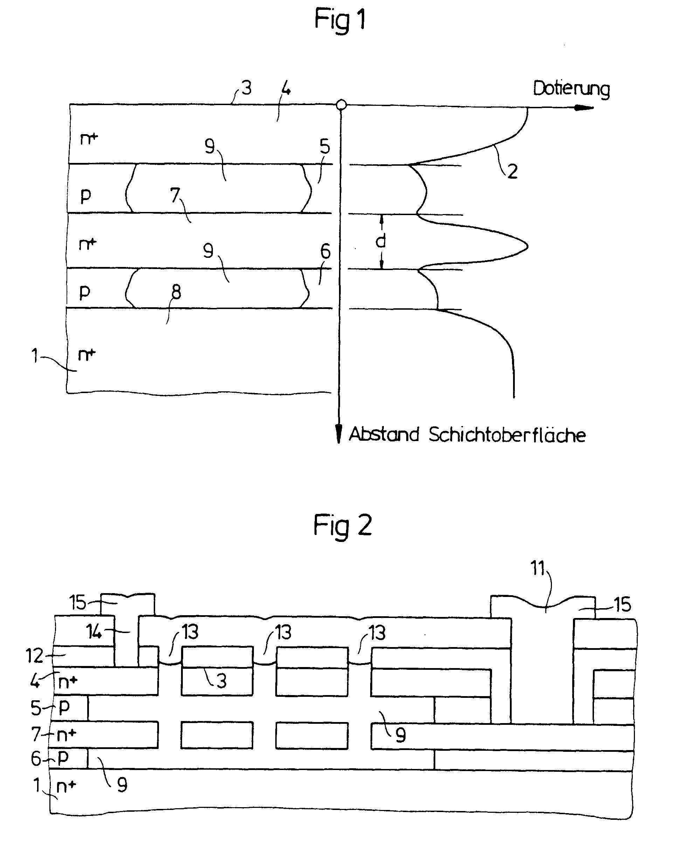

Anhand der schematischen Ansichten nach den Figuren 1 bis 3 wird im Folgenden die Herstellung einer mikromechanischen Halbleiteranordnung nach einem bevorzugten Ausführungsbeispiel der Erfindung erläutert. Dabei wird zunächst in einem monokristallinen Halbleitersubstrat 1 aus vorzugsweise Silizium ein Dotierungsprofil 2 über eine entsprechende Anzahl durchzuführender Hochenergieimplantationsschritte erzeugt. Ausgehend von der Schichtoberfläche 3 des Halbleitersubstrats 1 wird ein Bereich 4 für die Ausbildung einer späteren Deckschicht n⁺-dotiert, Bereiche 5 bzw. 6 zur späteren Ausbildung einer Auflager- bzw. Gegenlagerschicht werden p-dotiert, eine Membranschicht 7 mit einer Gesamtstärke d wird n⁺-dotiert, und ebenso eine verbleibender Bereich 8 des Halbleitersubstrats 1. Zweckmäßigerweise wird hierbei ausgehend von einem n⁺-dotierten Halbleitergrundkörper 8 in lediglich zwei durchzuführenden Implantationsschritten der Bereich 5 und der Bereich 6 p-dotiert. Ein Dotierungsschritt beinhaltet hierbei auch eine nachfolgende Hochtemperaturbehandlung zur Rekristallisation des dotierten Bereiches und Aktivierung der Dotierstoffe. Bei einer alternativen Herstellung der in Figur 1 dargestellten Schichtenfolge können ausgehend von einem n⁺-dotierten monokristallinen Halbleitergrundkörper 8 die weiteren Schichten 6, 7, 5 und 4 epitaktisch in der gewünschten Dotierung aufgebracht werden. In beiden Fällen ergibt sich eine monokristalline Schichtenfolge mit dem in Figur 1 dargestellten Dotierungsprofil, aus welcher in einem späteren Verfahrensschritt durch nass-chemisches Ätzen die innerhalb eines Hohlraums 9 angeordnete dünne Membran 7 gefertigt wird.

Gemäß Figur 2 wird daran anschließend an Stellen, an denen später Kontaktanschlüsse für die elektrische Ankopplung der Membran 7 erzeugt werden sollen, ein Kontaktloch 11 vermittels an sich bekannter Phototechnik- und Ätzschritte erzeugt. Daran anschließend wird ganzflächig eine Isolationsschicht 12 bestehend vorzugsweise aus Siliziumoxid abgeschieden und zur Entfernung des am Boden des Kontaktloches 11 liegenden Materials rückgeätzt. Im nächsten Schritt wird vermittels einer weiteren Phototechnik die Isolationsschicht 12 strukturiert, d.h. mit Öffnungen 13 versehen, die in einem nachfolgenden anisotropen Trockenätzschritt auf die Schichten 4, 5 und 7 abgebildet werden. Diese Ätzöffnungen ermöglichen das Eindringen der Ätzlösung in den nachfolgenden nass-chemischen Ätzschritten und damit durch isotrope Ätzung der Schichten 5 und 6 die Bildung des Hohlraums 9. Im Falle der Ätzung der niedrig dotierten Gebiete 5 und 6 eignet sich zu diesem Zweck beispielsweise eine KOH-Ätzlösung, welche ausreichend selektiv gegenüber den hoch dotierten Gebieten 4, 7, und 1 ist, die nicht oder jedenfalls nicht nennenswert geätzt werden sollen.

Nach der Fertigung der Membran 7 innerhalb des Hohlraums 9 werden die nicht mehr benötigten Löcher 13 im Bereich der aus der Isolationsschicht 12 gebildeten Abdeckung mit einem Oxid oder Borphosphorsilikatglas (BPSG) abgedeckt und verschlossen. An einer geeigneten Stelle wird ein weiteres Kontaktloch 14 geätzt und durch dieses ein metallischer Kontakt 15 auf die darunter liegende elektrisch leitende Schicht 4 geführt. Der Sensor kann jetzt bestimmungsgemäß durch die sich verändernden Kapazitäten zwischen der Membran 7 und der n⁺-dotierten Schicht 4 arbeiten.

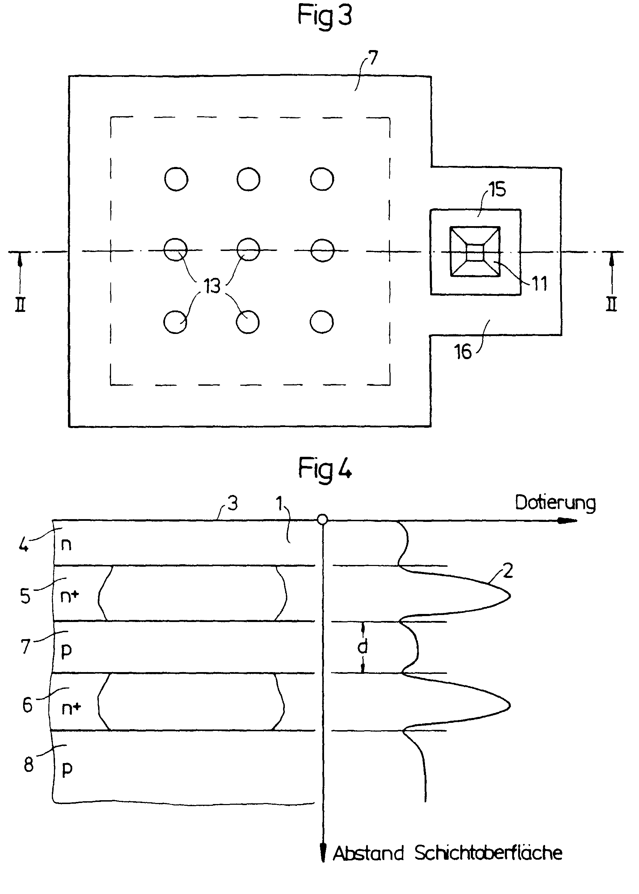

In Figur 3 ist eine Draufsicht auf den Sensor dargestellt, wobei die gestrichelte Linie die äußeren Abmessungen anzeigt, die durch die Auflagerschicht 6 bestimmt werden. Die Gegenlagerschicht 5 überdeckt zum Einen den Randbereich der Membran 7 und zum Anderen den rechts unten dargestellten Fortsatz 16 der Membran 7, in dem auch das Kontaktloch 11 angeordnet ist. In dem zentralen Bereich der Membran 7 sind die Ätzlöcher 13 angeordnet, die zum Durchleiten der Ätzflüssigkeit für die Erzeugung des Hohlraums in den die Membran 7 umgebenden Bereichen dient.

Figur 4 zeigt eine weitere Ausführungsform einer erfindungsgemäßen mikromechanischen Halbleiteranordnung mit einer innerhalb eines Hohlraums ausgebildeten dünnen Membran 7, bei der ausgehend von einem niedrig p-dotierten Siliziumgrundkörper 8 ein alternatives Dotierungsprofil mit hoch n⁺-dotierten Schichten 5 und 6 ausgebildet ist. Für die nass-chemische Ätzung der hoch dotierten Gebiete 5 und 6 eignet sich eine gegenüber der niedrig p-dotierten Schicht 7 der Membran selektive Ätzlösung bestehend aus beispielsweise HF-HNO₃-CH₃COOH.

## Patentansprüche

1. Verfahren zur Herstellung einer mikromechanischen Halbleiteranordnung, insbesondere einer mikroelektronischen integrierten Sensoranordnung, bei welcher innerhalb eines Hohlraums (9) eine Membran (7) durch eine kristalline Schicht innerhalb des Substrates (1) oder innerhalb einer auf einem Substrat (1) angeordneten epitaktischen Schichtenfolge der Halbleiteranordnung ausgebildet wird, wobei die Membran (7) am Randbereich an einem Auflager (6) aufgelegt, und mit einer auf einem Gegenlager (5) abgestützten Deckschicht (4) überdeckt wird, und wobei das Auflager (6) und das Gegenlager (5) einerseits und die Membran (7) andererseits aus Materialien mit unterschiedlichen Ätzraten gegenüber einem vorbestimmten nass-chemischen Ätzmittel gefertigt werden,
**dadurch gekennzeichnet** ,
daß in einer aus kristallinen Einzelschichten bestehenden Schichtenfolge aufweisend eine Auflagerschicht (6), Membranschicht (7), und Gegenlagerschicht (5) ein Dotierungsprofil mit einer abwechselnden oder variierenden Dotierung von Auflagerschicht (6), Membranschicht (7) und Gegenlagerschicht (5) erzeugt wird, und die Auflagerschicht (6) und die Gegenlagerschicht (5) wenigstens bereichsweise vermittels einem gegenüber der Membranschicht (7) selektiven Atzmittel nass-chemisch geätzt werden.

2. Verfahren nach Anspruch 1,
**dadurch gekennzeichnet** ,
daß die Membran (7) aus einer monokristallinen Silizium-Schicht gebildet wird.

3. Verfahren nach Anspruch 1 oder 2,
**dadurch gekennzeichnet**,
daß die Materialien für das Auflager (6) und das Gegenlager (5) einerseits und die Membran (7) andererseits unterschiedlich dotiert werden.

4. Verfahren nach einem der vorhergehenden Ansprüche,
**dadurch gekennzeichnet,**
daß die Membran (7) mit Ätzlöchern (13) versehen wird.

5. Verfahren nach einem der vorhergehenden Ansprüche,
**dadurch gekennzeichnet,**
daß das Auflager bzw. das Gegenlager (5) im gesamten Umfangsbereich der Membran (7) vorgesehen wird.

## Revendications

1. Procédé de fabrication d'un dispositif micromécanique à semiconducteur, notamment d'un dispositif capteur intégré microélectronique, dans lequel on réalise à l'intérieur d'une cavité (9) une membrane (7) par une couche cristalline à l'intérieur du substrat (1) ou à l'intérieur d'une succession de couches épitaxiales disposées sur un substrat (1) du dispositif à semiconducteur, la membrane (7) étant déposée dans la zone du bord sur un support (6) et étant recouverte d'une couche (4) de finition appliquée sur un appui (5), et le support (6) et l'appui (5), d'une part, et la membrane (7), d'autre part, étant fabriqués en des matériaux ayant des vitesses d'attaque chimique différentes par rapport à un agent d'attaque chimique en voie humide prédéterminée,
caractérisé en ce que
on produit dans une succession de couches, constituée de couches individuelles cristallines, comportant une couche (6) de support, une couche (7) de membrane et une couche (5) d'appui, un profil de dopage à dopage variant ou alternant de la couche (6) de support, de la couche (7) de membrane et de la couche (5) d'appui, et on attaque par une attaque chimique en voie humide, au moyen d'un agent d'attaque chimique sélectif par rapport à la membrane (7), au moins par zone la couche (6) de support et la couche (5) d'appui.

2. Procédé suivant la revendication 1,
caractérisé en ce que
la membrane (7) est formée d'une couche de silicium monocristalline.

3. Procédé suivant la revendication 1 ou 2,
caractérisé en ce que l'on dope différemment les matériaux pour le support (6) et l'appui (5), d'une part, et la membrane (7), d'autre part.

4. Procédé suivant l'une des revendications précédentes,
caractérisé en ce que l'on muni la membrane (7) de trous (13) d'attaque chimique.

5. Procédé suivant l'une des revendications précédentes,
caractérisé en ce que le support ou l'appui (5) sont prévus dans toute la zone périphérique de la membrane (7).

## Claims

1. Method for the production of a micromechanical semiconductor arrangement, in particular a microelectronic integrated sensor arrangement, in which, within a cavity (9), a diaphragm (7) is formed by a crystalline layer within the substrate (1) or within an epitaxial layer sequence of the semiconductor arrangement, the said layer sequence being arranged on' a substrate (1), the diaphragm (7) being placed on a support (6) at the edge region and being covered with a covering layer (4) supported on a counterbearing (5), and the support (6) and the counterbearing (5), on the one hand, and the diaphragm (7), on the other hand, being produced from materials having different etching rates with respect to a predetermined wet-chemical etching agent,
characterized
in that, in a layer sequence comprising crystalline individual layers and having a support layer (6), diaphragm layer (7), and counterbearing layer (5), a doping profile having an alternating or varying doping of support layer (6), diaphragm layer (7) and counterbearing layer (5) is produced, and the support layer (6) and the counterbearing layer (5) are etched wet-chemically at least in regions by means of an etching agent which is selected with respect to the diaphragm layer (7).

2. Method according to Claim 1,
characterized
in that the diaphragm (7) is formed from a monocrystalline silicon layer.

3. Method according to Claim 1 or 2,
characterized
in that the materials for the support (6) and the counterbearing (5), on the one hand, and the diaphragm (7), on the other hand, are doped differently.

4. Method according to one of the preceding claims,
characterized
in that the diaphragm (7) is provided with etching holes (13).

5. Method according to one of the preceding claims,
characterized
in that the support and/or the counterbearing (5) is provided in the entire peripheral region of the diaphragm (7).
